Europäisches Patentamt

European Patent Office

Office européen des brevets

(11) Numéro de publication: **0 195 722**
**B1**

(12) **FASCICULE DE BREVET EUROPEEN**

(45) Date de publication du fascicule du brevet:
**17.05.89**

(21) Numéro de dépôt: **86400585.5**

(22) Date de dépôt: **19.03.86**

(51) Int. Cl.⁴: **H05K 7/14**

(54) **Dispositif d'insertion et d'extraction de cartes électroniques.**

(30) Priorité: **22.03.85 FR 8504332**

(43) Date de publication de la demande:
**24.09.86 Bulletin 86/39**

(45) Mention de la délivrance du brevet:
**17.05.89 Bulletin 89/20**

(84) Etats contractants désignés:
**DE GB IT NL**

(56) Documents cités:
**DE-A- 2 213 639**
**DE-A- 2 647 837**
**GB-A- 2 118 782**
**US-A- 3 367 732**

(73) Titulaire: **THOMSON-CSF, 173, Boulevard Haussmann,
F-75379 Paris Cédex 08(FR)**

(72) Inventeur: **Lamy, Michel, THOMSON-CSF
SCPI 19, avenue de Messine, F-75008 Paris(FR)**
Inventeur: **Picardeau, Claude, THOMSON-CSF
SCPI 19, avenue de Messine, F-75008 Paris(FR)**

(74) Mandataire: **Benoit, Monique et al, THOMSON-CSF
SCPI, F-92045 PARIS LA DEFENSE CEDEX 67(FR)**

## Description

La présente invention concerne les dispositifs d'insertion et d'extraction de cartes électroniques dans leur bac récepteur.

L'insertion et l'extraction des cartes électroniques (en circuit imprimé) se fait généralement à l'aide d'un système à levier placé sur le bord accessible de la carte c'est-à-dire le bord avant; le bord non accessible de la carte c'est-à-dire le bord arrière étant destiné à réaliser les interconnexions avec le fond du bac récepteur. Le système à levier fixé sur la carte prend appui sur une traverse du bac et permet l'insertion et l'extraction de la carte, les efforts d'insertion et d'extraction étant appliqués sur le bord avant de cette carte. La carte est donc soumise à des contraintes qui entraînent la carte dans un mouvement de flexion ce qui peut provoquer une détérioration de la carte et/ou, des composants.

La force d'insertion ou d'extraction qu'il est nécessaire d'appliquer (et qui est de l'ordre de 27 kg) provoque des flexions d'autant plus importantes sur des cartes qui ont un format plus grand que celui qui est utilisé habituellement.

La présente invention permet de remédier à ce problème en proposant un dispositif d'insertion, d'extraction et de verrouillage qui agit directement au niveau des connecteurs et non à l'avant de la carte. Les efforts exercés par ce dispositif sont donc plus efficaces que les mêmes efforts appliqués à l'avant de la carte.

La présente invention a pour objet un dispositif d'insertion et d'extraction de cartes électroniques dans un bac récepteur, les cartes comportant sur un de leurs bords des connecteurs et étant insérées dans le bac par une face avant du bac récepteur et étant connectée à ce bac par une face arrière, opposée à cette face avant et qui comporte également des connecteurs, caractérisé en ce qu'il comporte des moyens d'insertion et d'extraction constitués par des moyens d'ancrage solidaires du bord de la carte où sont placés les connecteurs; des moyens d'entraînement de la carte, solidaires de l'arrière du bac et aptes à recevoir les moyens d'ancrage; et des moyens d'action aptes à communiquer aux moyens d'entraînement un mouvement de sorte que ces moyens entraînent la carte permettant d'appliquer un effort d'insertion ou d'extraction directement au niveau des connecteurs.

L'invention sera mieux comprise à l'aide de la description suivante présentée à titre d'exemple non limitatif et faite en regard des figures du dessin annexé sur lequel:

- la figure 1 représente une vue en perspective de l'invention;
- les figures 2, 3 et 4 représentent des détails de réalisation du mécanisme de la pièce amovible selon la figure 1 et de l'outil;
- les figures 5 et 6 représentent des détails schématiques des mécanismes selon les figures 2 et 3;
- la figure 7 représente un détail de réalisation des lames à ressort selon la figure 1.

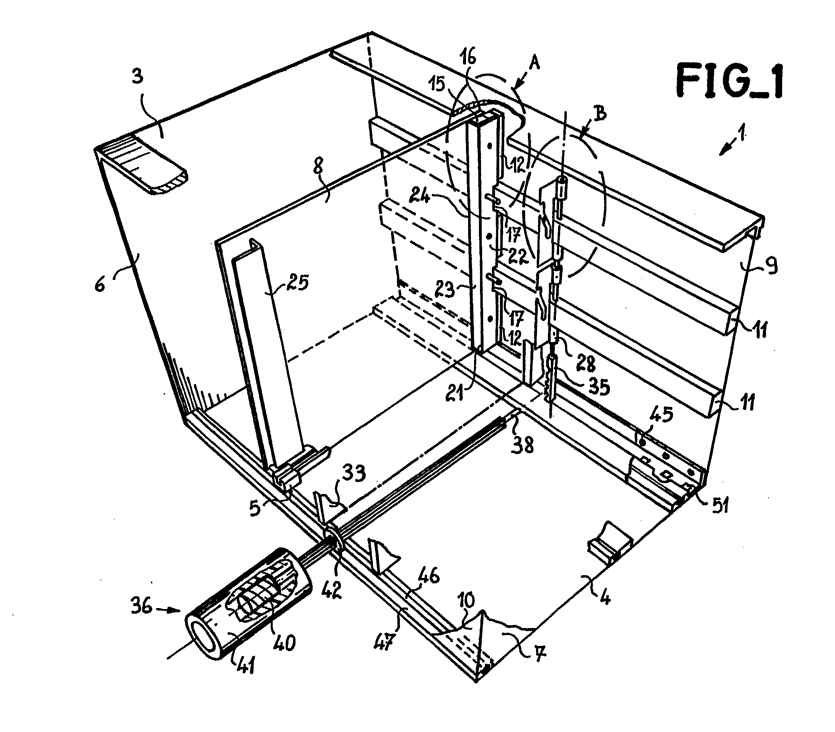

Sur la figure 1 on a représenté une vue d'ensemble du dispositif selon l'invention placé dans son environnement.

Le bac 1 récepteur est constitué par une cavité généralement parallélépipédique délimitée par deux premiers plans 3, 4 montés sur des traverses parallèles comportant des glissières 5 en vis-à-vis; deux plaques parallèles 6 et 7, sur lesquelles reposent le plan 3 et entre lesquelles sont insérées les cartes électroniques parallèlement les unes aux autres.

Pour simplifier la description on désignera par côtés latéraux les plaques 6 et 7 parallèles aux cartes 8, et dessus et dessous les plans 3 et 4 qui comportent les glissières, cette disposition étant relative à un mode de réalisation particulier tel que représenté sur la figure 1. Les cartes peuvent bien entendu selon un autre mode de réalisation être parallèles au-dessus et au-dessous, les bords latéraux étant munis de glissières. La cavité est également délimitée par une plaque que l'on qualifiera de plaque arrière 9 par opposition à la face avant 10 du bac par laquelle s'opère l'insertion et l'extraction des cartes. La plaque arrière comporte sur sa face interne à la cavité, des traverses 11 qui permettent de renforcer cette plaque. Les traverses sont placées sur la face interne arrière perpendiculairement aux côtés latéraux 6 et 7. Elles sont solidaires de cette face et des côtés latéraux. Les connecteurs 12 prennent appui sur ces traverses par l'intermédiaire de la plaque arrière.

La description qui suit se rapporte aux figures 1, 2, 3 et 4. Dans l'exemple particulier représenté on a choisi le format triple Europe, les cartes ayant par conséquent trois fichiers 12. Les fichiers sont constitués par des fiches de connexion disposées sur un support 15 fixé sur la bordure 16 de la carte destinée à l'interconnexion. Ils peuvent comporter également des moyens de détrompage classiques que l'on n'a pas représentés. Ces fiches se répartissent en trois groupes séparés par une discontinuité 17. Dans les deux intervalles 17 séparant les trois fichiers le support 15 comporte un logement qui porte les mêmes références que les intervalles, de dimensions adaptées à celles des sections des traverses de manière à ce que lorsque la carte est enfichée, les parties 18 des traverses situées au niveau des logements, s'encastrent dans les logements respectifs.

Une cornière 21 est fixée sur les supports 15 connecteurs par l'une de ses branches 22, l'autre branche ayant une arête 24 plaquée contre la carte imprimée dans un but de renforcer la carte. Une autre cornière 25 peut être fixée à l'avant de la carte dans un même but.

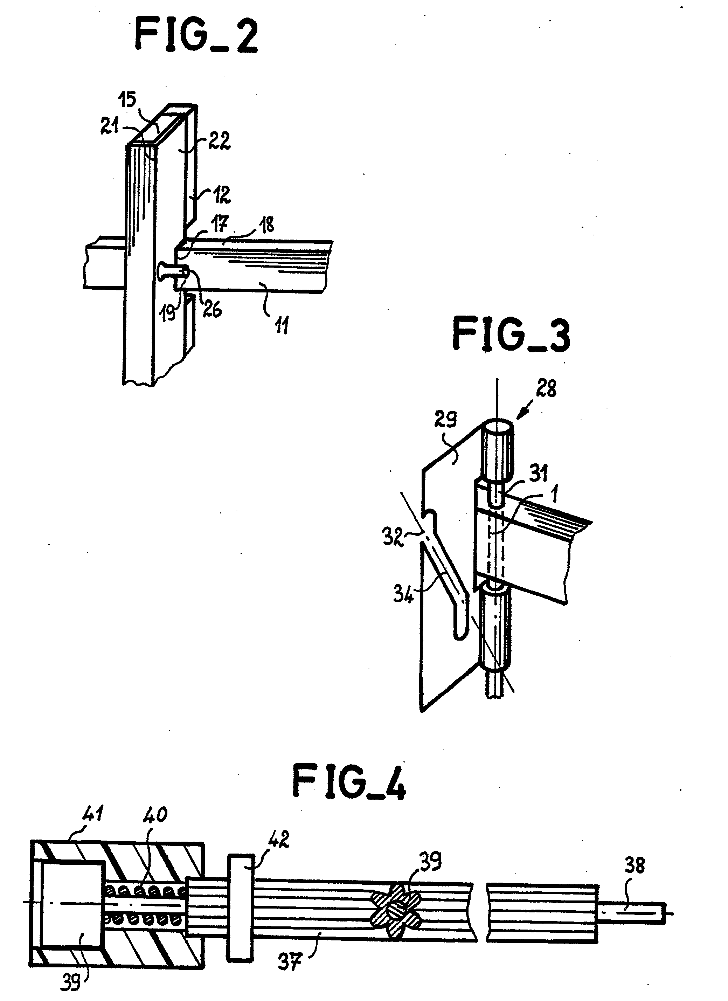

Le détail de réalisation A est représenté sur la figure 2. La cornière arrière 21 a également pour but de supporter des axes 26, de prises distribués le long de la branche 22 qui est parallèle à la carte 8. Chaque axe est placé dans la partie pleine restant après la découpe d'encoches 19 sur la branche 22, chaque encoche épousant la forme du logement de manière à ne pas gêner l'encastrement de la traverse. Dans l'exemple de réalisation particulier la cornière 21 comporte deux axes 26 qui sont réalisés par des ergots rigides perpendiculaires à la cornière.

La cornière 21 et les ergots 26 constituent des moyens d'ancrage.

L'invention comporte également une pièce métallique 28 amovible. Une partie détaillée B est représentée sur la figure 3. La pièce présente des méplats 29 parallèles à la carte et un axe de translation 31, vertical selon cette configuration particulière c'est-à-dire un axe parallèle à la bordure 16 de la carte qui supporte les connecteurs 12. L'axe de manoeuvre 31 traverse les traverses 11, il permet un déplacement vertical des méplats 29.

Les méplats possèdent chacun une encoche 32 destinée à recevoir l'ergot 26 qui se trouve en vis-à-vis lorsqu'une carte est placée dans les glissières. Pour plus de clarté la pièce métallique 28 représentée ne correspond pas à celle qui est destinée à entraîner la carte représentée, mais celle qui est destinée à entraîner une carte 33 placée en aval de celle-ci.

L'encoche 32 effectuée dans chaque méplat présente une partie 34 en forme de rampe, cette rampe est donc située sur un axe incliné par rapport à l'axe de la pièce.

Une crémaillère 35 est placée à l'une des extrémités de l'axe de manoeuvre 31 par exemple à l'extrémité basse, cette extrémité étant située du côté de la plaque de dessous du bac. Lorsque la carte est enfichée l'extrémité de chaque crémaillère pénètre dans un logement 51 emménagé dans une glissière transversale. La pièce 28 constitue des moyens d'entraînement de la carte.

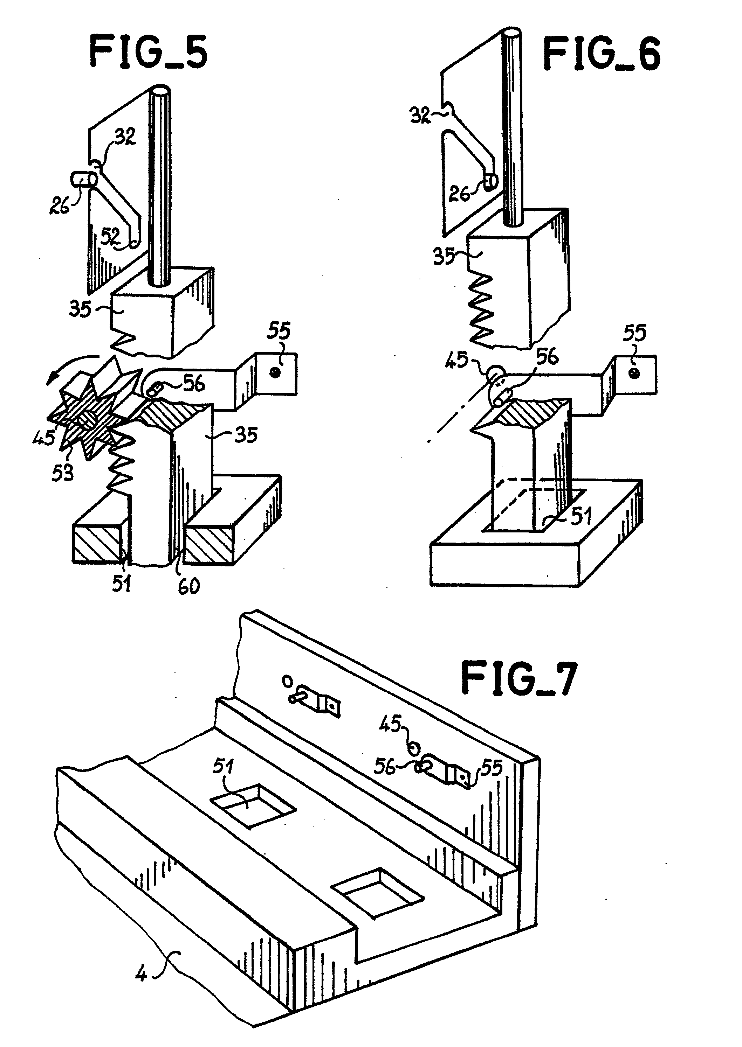

Un outil 36 représenté sur la figure 4 comportant un manche et une tige présentant des cannelures longitudinales, permet d'actionner la crémaillère. En effet la tige 37 de l'outil se présente sous la forme d'un pignon pour la crémaillère. Cette tige permet, lorsque l'outil est introduit entre deux glissières inférieures du bac et dirigé vers le fond, de s'engager dans la crémaillère et de communiquer un mouvement de translation à la pièce 28. La tige 37 de l'outil se termine par une pointe rétractable 38 commandée au moyen d'un axe-poussoir 39 comportant un ressort 40 emboîté dans le manche 41. La tige comporte également une bague 42 placée autour de celle-ci à proximité du manche 41.

Lorsque l'outil est introduit entre deux glissières, la pointe 38 de l'axe-poussoir 39 accoste un trou de centrage 45 qui pilote l'engagement du pignon formé par les cannelures de la tige, sur la crémaillère, cet engagement se poursuit par l'avancée de l'outil. La bague 42 située sur la tige à proximité du manche vient se loger dans une rainure 46 aménagée à cet effet dans le profil avant 47 du bac et maintient l'engrènement malgré la poussée d'éjection du ressort 40 du poussoir. La bague 42 bloque l'avance ou le recul de l'outil lorsque l'outil est en place.

Pour enficher une carte, on l'introduit entre ses glissières seule la glissière 5 du bas est représentée, puis on l'a rapproche du fond. Les axes d'équipement 26 (ou ergots) de celle-ci pénètrent dans l'encoche 32 du méplat 29 respectif. On positionne l'outil 36 de manière à engager le pignon dans la crémaillère. On applique un mouvement de rotation sur le manche de l'outil ce qui provoque le déplacement de la crémaillère 35 de la pièce 28, l'ergot 26 qui est entraîné dans la rampe 34 provoque une traction de la carte vers l'arrière du bac ce qui a pour effet l'enfichage des connecteurs.

Sur les figures 5 et 6, on a représenté schématiquement le mouvement de la pièce amovible support de la crémaillère.

La figure 5 représente la pièce support à l'état initial juste avant l'enfichage d'une carte. L'axe ou l'ergot 26, solidaire de la carte, est placé à l'entrée de l'encoche 32. L'extrémité 60, basse, de la crémaillère 35 est placée dans son logement 51. Le trou dans lequel est introduit la pointe de l'outil se trouve à une hauteur du plan horizontal tel qu'il autorise le déplacement de la crémaillère nécessaire pour que l'ergot 26 se trouve au fond 52 de l'encoche comme cela est représenté sur la figure 6.

Les dents 53 de l'outil 36 repoussent le téton 56 d'une lame ressort 55 solidaire du plan arrière 9, ce téton étant placé entre deux dents de la crémaillère. On applique dans cette configuration particulière un mouvement de rotation de la droite vers la gauche à l'outil pour faire translater la pièce de bas en haut. Les rapports d'engrenage entre le pignon et la crémaillère sont choisis de manière à permettre une démultiplication des efforts à appliquer sur le manche. Après insertion de la carte, figure 6, l'outil 36 est retiré.

Sur la figure 7, on a représenté le détail de réalisation des traverses qui se trouvent à l'intersection du plan arrière et du plan de dessous du bac et dans lesquelles se trouvent respectivement les lames 55, les trous 45 et les logements 51.

La traverse arrière comporte des trous 45 alignés et de même dimension, ces trous permettant de recevoir la pointe 38 de l'axe de l'outil lorsque celle-ci est dans sa position sortante. La traverse comporte également en-dessous de ces trous, les lames ressorts 55 également alignées, fixées à la traverse chacune par une partie. Ces lames comportent chacune un téton 56 à l'autre partie, c'est-à-dire à la partie flexible. En position de repos le téton vient se loger entre deux dents de la crémaillère et verrouille celle-ci après le retrait de l'outil. Lorsque l'outil est introduit, la partie 37 faisant office de pignon, repousse le téton 56 de la lame ressort 55.

Lorsque la carte est enfichée, on retire l'outil, le téton 56 de la lame se loge à nouveau entre deux dents de la crémaillère et verrouille ainsi la position de la crémaillère 35.

En conclusion, l'invention permet d'insérer et d'extraire des cartes de leur bac récepteur sans risque de détérioration de ces cartes car l'effort d'insertion et d'extraction de ces cartes est directement appliqué au niveau des fichiers connecteurs. De plus, l'effort à appliquer est moindre grâce à l'utilisation d'un mécanisme à engrenage qui permet une démultiplication de cet effort.

Par ailleurs, le dispositif comporte également un mécanisme de verrouillage de la carte par action sur la crémaillère.

**Revendications**

1. Dispositif d'insertion et d'extraction de cartes électroniques dans un bac récepteur, dans lequel les cartes comportent sur un de leurs bords des connecteurs et sont insérées dans le bac par une face avant du bac récepteur et sont connectées à ce bac par une face arrière, opposée à cette face avant et qui comporte également des connecteurs, caractérisé en ce qu'il comporte des moyens d'insertion et d'extraction constitués par des moyens d'ancrage (21, 26) solidaires du bord (16) de la carte (8) où sont placés les connecteurs (12); des moyens d'entraînement (28) de la carte, solidaires de l'arrière du bac et aptes à recevoir les moyens d'ancrage; et des moyens d'action (36) aptes à communiquer aux moyens d'entraînement (28) un mouvement de sorte que ces moyens d'entraînement (28) entraînent la carte (8) permettant d'appliquer un effort d'insertion ou d'extraction directement au niveau des connecteurs.

2. Dispositif selon la revendication 1, caractérisé en ce qu'il comporte des moyens de verrouillage (55) des moyens d'entraînement (28).

3. Dispositif selon la revendication 1 ou 2, caractérisé en ce que les moyens d'ancrage (21, 26) sont constitués par des axes rigides (26) distribués sur une cornière (21) solidaires du bord de la carte comportant les connecteurs (12).

4. Dispositif selon l'une quelconque des revendications 1 à 3, caractérisé en ce que les moyens d'entraînement sont constitués par une pièce rigide amovible (28) comportant des encoches (32) à rampe dans lesquelles viennent se placer les axes (26) et qui entraînent ces axes lorsque la pièce est en mouvement.

5. Dispositif selon la revendication 4, caractérisé en ce que les moyens d'entraînement comportent une crémaillère (35) permettant de déplacer la pièce selon un axe (31) qui permet de faire glisser les axes rigides le long de la rampe (34).

6. Dispositif selon l'une quelconque des revendications 1 à 5, caractérisé en ce que les moyens d'action sont constitués par un outil (36) comportant une manche (41) et une tige (37), la tige ayant une partie de son extrémité en forme de pignon.

7. Dispositif selon la revendication 6, caractérisé en ce que l'outil comporte un axe-poussoir (39) et un ressort (40), l'axe étant logé dans la tige et étant rétractable; le ressort étant logé dans le manche.

8. Dispositif selon la revendication 7, caractérisé en ce que la tige comporte une bague de blocage (42) de l'outil et en ce que le bac comporte sur son profil avant (47) une rainure (42) destinée à recevoir la bague.

9. Dispositif selon la revendication 7 ou 8, caractérisé en ce que l'extrémité (38) de l'axe-poussoir est rétractable, elle permet lorsqu'elle est en position sortante de guider le positionnement de l'outil, la plaque arrière (9) comportant des logements (45) aptes à recevoir cette extrémité.

10. Dispositif selon la revendication 2, caractérisé en ce que les moyens de verrouillage (55, 56) comportent pour chaque crémaillère, une lame à ressort (55) comprenant un doigt (56), la lame étant solidaire du bac et le doigt étant en position stable, entre deux dents de la crémaillère.

11. Dispositif selon l'une quelconque des revendications 1 à 10, caractérisé en ce que le dispositif comporte des moyens de détrompage au niveau des connecteurs.

## Patentansprüche

1. Vorrichtung zum Einschieben und Herausnehmen von Elektronikkarten in einem Aufnahmegehäuse, in welcher die Karten an einem ihrer Ränder Verbinder umfassen und in das Gehäuse durch eine Vorderfläche des Aufnahmegehäuses eingeschoben werden und mit diesem Gehäuse über eine Rückfläche verbunden sind, welche dieser Vorderfläche abgewandt ist und ebenfalls Verbinder umfaßt, dadurch gekennzeichnet, daß sie Mittel zum Einschieben und Herausnehmen umfaßt, welche aus Verankerungsmitteln (21, 26) bestehen, die mit dem Rand (16) der Karte (8), an welchem die Verbinder (12) angeordnet sind, fest verbunden sind; daß sie Mittel (28) zum Antrieb der Karte umfaßt, welche mit dem hinteren Teil des Gehäuses fest verbunden und dazu geeignet sind, die Verankerungsmittel aufzunehmen, sowie Betätigungsmittel (36) umfaßt, welche in der Lage sind, den Antriebsmitteln (28) eine Bewegung aufzugeben, da daß diese Antriebsmittel (28) die Karte (8) antreiben und es ermöglichen, eine Einschub- bzw. Herausnahmekraft unmittelbar an den Verbindern anzulegen.

2. Vorrichtung nach Anspruch 1, dadurch gekennzeichnet, daß sie Mittel (55) zur Verriegelung der Antriebsmittel (28) umfaßt.

3. Vorrichtung nach Anspruch 1 oder 2, dadurch gekennzeichnet, daß die Verankerungsmittel (21, 26) aus starren, auf einer Eckleiste verteilten Achsen (26) bestehen, welche mit dem die Verbinder (12) umfassenden Rand der Karte fest verbunden sind.

4. Vorrichtung nach einem der Ansprüche 1 bis 3, dadurch gekennzeichnet, daß die Antriebsmittel aus einem starren abnehmbaren Teil (28) gebildet sind, das mit einer Rampe versehene Schlitze (32) umfaßt, in welchen die Achsen (26) untergebracht sind und die diese Achse antreiben, wenn das Teil in Bewegung ist.

5. Vorrichtung nach Anspruch 4, dadurch gekennzeichnet, daß die Antriebsmittel eine Zahnstange (35) umfassen, die es ermöglicht, das Teil entlang einer Achse (31) zu bewegen, die ein Gleiten der starren Achsen entlang der Rampe (34) ermöglicht.

6. Vorrichtung nach einem der Ansprüche 1 bis 5, dadurch gekennzeichnet, daß die Betätigungsmittel aus einem mit einem Griff (41) sowie einer Stange (37) versehenen Werkzeug (36) bestehen, wobei ein Endteil der Stange als Ritzel geformt ist.

7. Vorrichtung nach Anspruch 6, dadurch gekennzeichnet, daß das Werkzeug eine Schubachse (39) sowie eine Feder (40) umfaßt, wobei die Achse in der Stange untergebracht und in diese einziehbar ist und die Feder in dem Griff untergebracht ist.

8. Vorrichtung nach Anspruch 7, dadurch gekennzeichnet, daß die Stange einen Blockierring (42) des Werkzeuges umfaßt und daß das Vorderprofil (47) des Gehäuses eine Rille (42) umfaßt, welche dazu bestimmt ist, den Ring aufzunehmen.

9. Vorrichtung nach Anspruch 7 oder 8, dadurch gekennzeichnet, daß das Ende (38) der Schubachse einziehbar ist und daß es in seiner Austrittposition die Lenkung der Werkzeugeinstellung ermöglicht, wobei die Hinterplatte (9) Aufnahmen (45) umfaßt, welche dazu geeignet sind, dieses Ende aufzunehmen.

10. Vorrichtung nach Anspruch 2, dadurch gekennzeichnet, daß die Verriegelungsmittel (55, 56) für jede Zahnstange ein mit einem Finger (56) versehenes Federblatt (55) umfaßt, wobei das Blatt mit dem Gehäuse fest verbunden ist und der Finger zwischen zwei Zähnen der Zahnstange in einer stabilen Lage ist.

11. Vorrichtung nach einem der Ansprüche 1 bis 10, dadurch gekennzeichnet, daß sie verwechslungssichere Mittel an den Verbindern umfaßt.

**Claims**

1. A device for the insertion and extraction of electronic circuit boards in a receiving box, in the case of which on their edge the cards comprise connectors and are inserted in the box through the front side of the receiving box and are connected with the box through the rear side, opposite to the front side and which also comprises connectors, characterized in that it comprises means for the insertion and extraction constituted by anchoring means (21 and 26) fixed to the edge (16) of the card (8), where the connectors (12) are placed; means (28) for the entrainment of the board, fixed in relation to the rear of the box and adapted to receive anchoring means; and acting means (36) adapted to impart motion to the entrainment means (28) in such a manner that such entrainment means (28) entrain the board (8) making it possible to apply an inserting and extracting force directly at the level of the connectors.

2. The device as claimed in claim 1 characterized in that it comprises latching means (55) for the entrainment means (28).

3. The device as claimed in claim 1 or claim 2, characterized in that the anchoring means (21 and 26) are constituted by rigid pins (26) distributed on a bracket (21) and fixed to the edge of the board comprising the connectors (12).

4. The device as claimed in any one of the claims 1 through 3, characterized in that the entrainment means are constituted by a moving rigid member (28) comprising recesses (32) with ramps in which the pins (26) take up positions and which entrain these pins when the member is moving.

5. The device as claimed in claim 4, characterized in that the entrainment means comprise a rack (35) making it possible to displace the member along one pin (31) so that the rigid pins may be slid along the ramp (34).

6. The device as claimed in any one of the claims 1 through 5, characterized in that the acting means are constituted by a tool (36) comprising a handle (41) and a rod (37), the rod having a part of its end in the form of a pinion.

7. The device as claimed in claim 6, characterized in that the tool comprises a thrust pin (39) and a spring (40), the pin being received in the rod and being able to be retracted, the spring being received in the handle.

8. The device as claimed in claim 7, characterized in that the rod comprises a locking ring (42) of the tool and in that the box comprises a groove (42) on its front section (47) destined to receive the ring.

9. The device as claimed in claim 7 or claim 8, characterized in that the end (38) of the thrust pin is retractable, and when it is in its emerged position it makes it possible to guide the positioning of the tool, the rear plate (9) comprising sockets (45) adapted to receive this end.

10. The device as claimed in claim 7 or claim 8, characterized in that the latching means (55 and 56) comprise, for each rack, a spring blade (55) comprising a finger (56), the blade being fixed to the box and the finger being in a stable position, between two teeth of the rack.

11. The device as claimed in any one of the claims 1 through 10, characterized in that the device comprises means for realignment at the level of the connectors.

FIG_1

## FIG_2

15
21
22
12
17
18
19
26
11

## FIG_3

28
29
31
1
32
34

## FIG_4

41
40
42
39
38
39
37

# FIG_5

# FIG_6

# FIG_7